# EUROPÄISCHE PATENTSCHRIFT

(11) **EP 4 010 955 B1**
(45) Veröffentlichungstag und Bekanntmachung des Hinweises auf die Patenterteilung: **03.05.2023**
(21) Anmeldenummer: 20754705.0
(22) Anmeldetag: 07.08.2020
(51) Int. Cl.: H02H 7/122, H02M 1/32, H03K 17/0814, H03K 17/16, H02M 7/5387

(54) **STEUERUNGSVORRICHTUNG SOWIE BRÜCKENSCHALTUNG MIT EINER DERARTIGEN STEUERUNGSVORRICHTUNG**
CONTROL DEVICE AND BRIDGE CIRCUIT COMPRISING SUCH A CONTROL DEVICE
DISPOSITIF DE COMMANDE ET MONTAGE EN PONT COMPORTANT UN TEL DISPOSITIF DE COMMANDE

(30) Priorität: 09.08.2019 DE 102019121514
(43) Veröffentlichungstag der Anmeldung: 15.06.2022
(73) Patentinhaber: thyssenkrupp Presta AG, 9492 Eschen (LI); thyssenkrupp AG, 45143 Essen (DE)
(72) Erfinder: KALAPOS, Gábor, 2230 Gyömro (HU)
(74) Vertreter: thyssenkrupp Intellectual Property GmbH
(86) Internationale Anmeldenummer: PCT/EP2020/072218
(87) Internationale Veröffentlichungsnummer: WO 2021/028329

(56) Entgegenhaltungen:
- DE-A1-102010 033 440
- DE-A1-102011 055 626
- US-B1- 8 514 600
- US-B2- 9 065 275

## Beschreibung

Die vorliegende Erfindung betrifft eine Steuerungsvorrichtung für ein Leistungsmodul bzw. einen Wechselrichter, insbesondere für eine Brückenschaltung zur gesteuerten Wechselstromerzeugung. Ebenso bezieht sich die Erfindung auf eine Brückenschaltung, die eine derartige Steuervorrichtung aufweist.

Ein Wechselrichter (engl. Inverter) ist ein elektrisches Gerät, das Gleichspannung in Wechselspannung umwandelt. Eine Brückenschaltung ist eine beispielhafte Ausgestaltung eines Wechselrichters, weist einen oder mehrere parallelgeschaltete Brückenzweige auf und kann mittels eines Pulsweitenmodulationssignals einen sinusförmigen Wechselstrom bzw. -spannung erzeugen. Ein Brückenzweig wird durch mindestens einen High-Side (kurz HS) Schalter und mindestens einen Low-Side (kurz LS) Schalter gebildet, wobei ein Wechselstromausgang zwischen beiden Schaltern liegt. Der HS Schalter liegt an einem Potential und der LS Schalter an dem anderen Potential der Gleichspannung an.

In der jetzigen Zeit werden Halbleitungsleistungsschalter wie z.B. Feldeffekttransistoren (abgekürzt als FET) als Isolatoren bzw. Schalter zwischen Wechselrichtern bzw. Leistungsmodulen und den anzutreibenden elektrischen Motoren verwendet, um im Falle eines Kurzschlusses, z.B. im Leistungsmodul, den elektrischen Motor davon elektrisch zu trennen. Diese Isolierung bzw. Trennung ist notwendig, um den Bremseffekt des elektrischen Motors zu reduzieren. Allerdings ist das Deaktivieren eines Phasenisolators, der im eingeschalteten bzw. leitenden Zustand das Leistungsmodul mit dem elektrischen Motor verbindet, nicht immer unproblematisch, da bei einem plötzlichen Unterbrechen des Stroms die Induktion des elektrischen Motors eine Hochspannungsspitze erzeugen kann, die die Bauteile des Wechselrichters und andere Schaltelemente, wie z.B. den Phasenisolator, beschädigen und sogar zerstören kann.

Gemäß dem Stand der Technik existieren zahlreiche Lösungen, die basierend auf der Rotorwinkelgeschwindigkeit des Elektromotors den Phasenisolator deaktivieren. Allerdings sind diese Lösungen mit hohen Herstellungskosten verbunden, insbesondere für Phasenisolatoren, da nur eine indirekte Korrelation zwischen der Winkelgeschwindigkeit und der Stromunterbrechungsfähigkeit der Phasenisolatoren existiert und somit eine Überdimensionierung der Phasenisolatoren zum Schutz vor Hochspannungsspitzen notwendig ist. Es existieren auch zahlreiche weitere Verfahren zum Deaktivieren der Phasenisolatoren, die auf dem Detektieren eines Null-Amper-Stroms durch die Phasenisolatoren basieren. Hierzu sind jedoch zusätzliche Strommesser in den Drehstrom-Phasen notwendig, um die Phasenisolatoren an diesem spezifischen Punkt von Null-Amper zu trennen bzw. mit deren Hilfe die Phasenleitung zu unterbrechen.

Es wird darauf hingewiesen, dass die elektrischen Motoren oftmals mit Drehstrom versorgt werden, wobei jede Phase ein sinusförmiges Signal bildet und um 120° zu den anderen Phasen verschoben ist. Diese Phasen werden als Phase U, Phase V und Phase W bezeichnet.

Aus der DE 10 2011 055626 A1 ist eine Steuerungsvorrichtung der eingangs genannten Art bekannt. Auch die US 8 514 600 B1, die DE 10 2010 033440 A1 und die US 9 065 275 B2 dokumentieren Steuerungsvorrichtungen gemäß dem Stand der Technik.

Der Erfindung liegt die Aufgabe zugrunde, die zuvor genannten Probleme und Nachteile zu umgehen oder diese zumindest zu minimieren. Insbesondere soll eine Vorrichtung angegeben werden, die verschiedene Szenarien wie z.B. Kurzschlüsse erkennt und anschließend die Phasenisolierung durchführt. Die Vorrichtung sollte hierbei eine zuverlässige Stromunterbrechung ermöglichen, einfach und kostengünstig herzustellen sein und eine lange Lebensdauer aufweisen.

Zur Lösung der zuvor genannten Aufgabe stellt die vorliegende Erfindung eine Steuerungsvorrichtung für einen Wechselrichter, insbesondere für eine Brückenschaltung zur gesteuerten Wechselstromerzeugung, nach Anspruch 1 bereit.

Im Detail handelt es sich hierbei um eine Steuerungsvorrichtung für eine Brückenschaltung zur gesteuerten Wechselstromerzeugung. Die Brückenschaltung ist mit mindestens einem Brückenzweig ausgestattet, der mindestens einen High-Side Feldeffekttransistor, FET, mindestens einen Low-Side FET und einen dazwischenliegenden Wechselstromausgang aufweist. Die Steuerungsvorrichtung weist
- einen Spannungsmesser für jeden FET eines Brückenzweigs, wobei jeder Spannungsmesser zur Drain-Source-Spannungsmessung mit den jeweiligen FET verbindbar ist und Mess- und/oder Zustandswerte ausgibt;
- einen Feldeffekttransistor als Phasenisolator für jeden Wechselstromausgang, wobei der/die Phasenisolator/en mit jeweils einem Wechselstromausgang verbindbar und durch jeweils ein Steuersignal schaltbar ist/sind; und
- eine Logikschaltung zur Erfassung der Werte der Spannungsmesser und zur Ausgabe von Steuersignalen an jeweils einen Phasenisolator auf. Die Logikschaltung ist ausgelegt, anhand der erfassten Werte die Steuersignale zum Sperren des/der entsprechenden Phasenisolators/en auszugeben.

Die Messung des Spannungsabfalls erfolgt am FET, insbesondere an seiner Bodydiode, um die Stromstärke - qualitativ und/oder quantitativ - und die Stromrichtung der jeweiligen Phase zu bestimmen. Daher ist der Drain- und Source-Anschluss eines jeden FET mit einem Spannungsmesser elektrisch verbunden; d.h. die Anzahl der Spannungsmesser entspricht der Anzahl der FET der Brückenschaltung. Die Spannungsmessung erfolgt an den HS und/oder LS FETS. Die Logikschaltung empfängt ein Sperrsignal, das anzeigt, dass ein oder mehrere bestimmte oder alle Phasen von der Brückenschaltung getrennt bzw. unterbrochen werden sollen.

Die Steuerungsvorrichtung hat den Vorteil, durch eine geringe Anzahl von Bauteilen bestimmte Eigenschaften aus der Brückenschaltung bzw. dem Wechselrichter herauszumessen. Sobald diese Eigenschaften bzw. Zustands- oder Messwerte erzeugt und an die Logikschaltung weitergegeben wurden, wird bestimmt, dass ein Steuersignal zum Unterbrechen des Phasenisolators ausgegeben werden kann. Vorzugsweise werden die Spannungen periodisch, d.h. in zeitlich konstanten Abständen, oder in Echtzeit gemessen, um den Wechselstrom in den verschiedenen Phasen zu bestimmen.

Gemäß der Erfindung ist vorgesehen, dass die Spannungsmesser ausgelegt sind, einen ersten und einen zweiten Zustand zu bestimmen und auszugeben:
- der erste Zustand liegt vor, wenn die gemessene Spannung unterhalb eines vorbestimmten Werts, insbesondere unterhalb von -0,5 Volt, liegt, und dient zum Bestimmen der Stromrichtung; und
- der zweite Zustand liegt vor, wenn die gemessene Spannung oberhalb des vorbestimmten Werts, insbesondere oberhalb von -0,5 Volt, liegt, und dient zum Bestimmen, dass entweder kein Strom durch die Bodydiode des FET fließt oder der FET einen Drain-Source-Kurzschluss hat und beschädigt ist.

Die Erfindung hat den Vorteil, dass der Spannungsmesser zusätzlich zu seinen Messwerten einen Zustandswert bestimmen kann, der der Logikschaltung zur Verfügung gestellt wird und somit Aussagen über die Brückenschaltung und ihren Zustand gemacht werden können. Beim ersten Zustand wird insbesondere festgestellt, dass der Strom durch die Bodydiode fließt, wodurch die Stromrichtung bestimmt werden kann.

In einer weiteren vorteilhaften Ausführungsform weist die Steuerungsvorrichtung eine Hauptsteuerschaltung (auch als EPAS bezeichnet) auf oder ist mit dieser verbindbar, wobei die EPAS den vorbestimmten Wert zu jeder Zeit und insbesondere während des Betriebs der Steuerungsvorrichtung und/oder der Brückenschaltung bestimmen kann. Hierzu ist die EPAS z.B. mit den Daten der FET ausgestattet und kann anhand der gemessenen Spannungswerte Aussagen über den Zustand der FET und/oder deren Bodydiode treffen. Zusätzlich oder alternativ kann die Hauptsteuerschaltung das Sperrsignal an die Logikschaltung ausgeben. Die Ausgabe des Sperrsignals kann manuell durch eine Eingabe eines Benutzers und/oder automatisch durch eine Elektronik- oder Messschaltung, wie z.B. den und/oder anderen Spannungsmessern, veranlasst werden.

In einer weiteren bevorzugten Ausführungsform ist/sind der Source-Anschluss des/der Phasenisolator/en mit einer mit dem Wechselstrom zu versorgenden Last verbindbar. Hierbei handelt es sich um eine erste vorteilhafte Anordnung der Phasenisolatoren, die mit ihrem Drain-Anschluss an dem Wechselstromausgang bzw. mit ihrem Source-Anschluss an der Last verbindbar bzw. verbunden sind. Die Logikschaltung ist insbesondere derart konfiguriert, diese Anordnung bei der Steuerung der Phasenisolatoren zu berücksichtigen.

Vorzugsweise ist die Logikschaltung ausgelegt, beim Erfassen einer durch einen Spannungsmesser gemessenen Stromführung an einem High-Side FET ein Steuersignal zum Sperren des Phasenisolators des zugehörigen High-Side FET Wechselstromausgangs auszugeben. Anders formuliert: das Steuersignal kann vorzugsweise erst dann ausgegeben werden, wenn die entsprechende Stromführung gemessen wird. Aufgrund der Anordnung des Phasenisolators kann der entsprechende High-Side-FET verwendet werden, um den entsprechenden Phasenisolator zu sperren. Trotz der Sperrung des Phasenisolators kann weiterhin ein Strom von der Spule des Elektromotors, insbesondere dessen Phase, über die Bodydiode des Phasenisolators und die Bodydiode des High-Side FETs abgeleitet werden. Dadurch wird eine plötzliche Unterbrechung des Stroms in der entsprechenden Phase bzw. eine Hochspannungsspitze durch die Spule des Elektromotors vermieden.

Des Weiteren kann die Logikschaltung ausgelegt sein, anhand der erfassten Werte zu bestimmen, dass der High-Side FET keinen Kurzschluss aufweist und eine Stromführung in der Bodydiode des High-Side FET in die leitende Richtung der Bodydiode des entsprechenden Phasenisolators erfolgt, und somit das Steuersignal zum Sperren des Phasenisolators des zugehörigen High-Side FET Wechselstromausgangs auszugeben. Aufgrund der Mess- und Zustandswerte des Spannungsmessers am High-Side FET kann und wird bestimmt werden, dass kein Kurzschluss an diesem FET vorliegt und eine Stromführung durch die Bodydiode des High-Side FET und die Bodydiode des entsprechenden Phasenisolators in die gleiche Richtung erfolgt. Sobald diese Bedingungen erkannt werden, wird ein entsprechendes Steuersignal zum Sperren des Phasenisolators ausgegeben und der Strom kann weiterhin durch die entsprechenden Bodydioden durchfließen.

Vorzugsweise ist die Logikschaltung ausgelegt, anhand der erfassten Werte zu bestimmen, dass der Low-Side FET keinen Kurzschluss aufweist und eine Stromführung in der Bodydiode des Low-Side FET in die leitende Richtung der Bodydiode des entsprechenden Phasenisolators erfolgt, und die Werte keine Stromführung in der Bodydiode des High-Side FET auf derselben Phase signalisieren, und somit das Steuersignal zum Sperren des Phasenisolators des zugehörigen Low-Side FET Wechselstromausgangs auszugeben.

Ebenso kann die Logikschaltung ausgelegt sein, nachdem zwei beliebige Phasenisolatoren bereits deaktiviert sind, anhand der erfassten Werte zu bestimmen, dass keine Stromführung in der Bodydioden der entsprechenden Low-Side FETs in die leitende Richtung erfolgt und die Werte keine Stromführung in der Bodydiode des High-Side FET auf der letzten Phase signalisieren, und somit das Steuersignal zum Sperren des Phasenisolators des letzten Low-Side FET Wechselstromausgangs auszugeben.

Des Weiteren kann die Logikschaltung ausgelegt sein, Steuersignale zum Sperren eines Phasenisolators auszugeben, wenn ein Spannungsmesser für die High-Side FET gerade seinen Zustand von einer Stromführung in der Bodydiode auf keine Stromführung in der Bodydiode ändert und die Spannungsmesser für die Low-Side FETs keine Stromführung in der Bodydiode auf den beiden anderen Phasen zeigen.

In einer weiteren bevorzugten Ausführungsform ist/sind der Drain-Anschluss des/der Phasenisolator/en mit der mit dem Wechselstrom zu versorgenden Last verbindbar ist/sind. Hierbei handelt es sich um eine zweite vorteilhafte Anordnung der Phasenisolatoren, die mit ihrem Source-Anschluss an dem Wechselstromausgang bzw. mit ihrem Drain-Anschluss an der Last verbindbar bzw. verbunden sind. In diesem Fall ist die Bodydiode derart geschalten, dass ein Strom von dem Brückenzweig der Brückenschaltung zu der Spule fließen kann. Die Logikschaltung ist insbesondere derart konfiguriert, diese Anordnung bei der Steuerung der Phasenisolatoren zu berücksichtigen.

Vorzugsweise ist die Logikschaltung ausgelegt, beim Erfassen einer durch einen Spannungsmesser gemessenen Stromführung an einem Low-Side FET ein Steuersignal zum Sperren des Phasenisolators des zugehörigen Low-Side FET Wechselstromausgangs auszugeben. Diese vorteilhafte Ausgestaltung erlaubt es festzustellen, wann der Phasenisolator der entsprechenden Phase gesperrt werden kann. Hierzu muss die Bodydiode des Low-Side FET eine Stromführung aufweisen.

Ebenso kann die Logikschaltung ausgelegt sein, anhand der erfassten Werte zu bestimmen, dass der Low-Side FET keinen Kurzschluss aufweist und eine Stromführung in der Bodydiode des Low-Side FET in die leitende Richtung der Bodydiode des entsprechenden Phasenisolators erfolgt, und somit das Steuersignal zum Sperren des Phasenisolators des zugehörigen Low-Side FET Wechselstromausgangs auszugeben. Diese vorteilhafte Ausgestaltungsform beschreibt zwei Bedingungen, zu denen der Phasenisolator durch ein Steuersignal gesperrt werden kann.

Vorzugsweise ist die Logikschaltung ausgelegt, Steuersignale zum Sperren aller Phasenisolatoren auszugeben, wenn kein Spannungsmesser eine Stromführung misst. Dies beschreibt einen Fall, der ein Sperren aller Phasenisolatoren notwendig macht. Hierbei kann es sich insbesondere um einen Kurzschluss der Gleichspannungsversorgung handeln.

Ebenso kann die Logikschaltung ausgelegt sein, Steuersignale zum Sperren aller Phasenisolatoren auszugeben, wenn alle Spannungsmesser auf der High-Side mindestens einmal eine Stromführung in der Bodydiode des High-Side FET zeigten, ohne dass ein Spannungsmesser eine Stromführung in der Bodydiode des Low-Side FET zeigte.

Des Weiteren hat es sich als vorteilhaft gezeigt, wenn die Logikschaltung ausgelegt ist, ein externes Sperrsignal, das nicht von den Spannungsmessern stammt, zu erfassen bzw. zu empfangen und basierend auf diesem Sperrsignal die Phasenisolierung durch Ausgabe der Steuersignale an die Phasenisolatoren zu initiieren. Ebenso kann alternativ oder zusätzlich das Sperrsignal anhand der erfassten Werte der Spannungsmesser durch die Logikschaltung selbst erzeugt werden. Die Werte der Spannungsmesser geben der Logikschaltung die Bedingungen bzw. Voraussetzungen an, zu welchem Zeitpunkt der Phasenisolator abgeschaltet bzw. gesperrt werden kann.

Die vorliegende Erfindung betrifft ebenfalls eine 3-phasige Brückenschaltung mit einer erfindungsgemäßen Steuerungsvorrichtung nach einem der zuvor genannten Aspekte bzw. Ausführungen.

Die nachfolgend beschriebenen Figuren beziehen sich auf bevorzugte Ausführungsbeispiele der erfindungsgemäßen Steuerungsvorrichtung, wobei diese Figuren nicht als Einschränkung, sondern im Wesentlichen der Veranschaulichung der Erfindung dienen. Elemente aus unterschiedlichen Figuren, aber mit denselben Bezugszeichen, sind identisch; daher ist die Beschreibung eines Elements aus einer Figur für gleich bezeichnete bzw. gleich nummerierte Elemente aus anderen Figuren auch gültig.

Es zeigen
- Fig. 1: eine 3-phasige Brückenschaltung mit einer erfindungsgemäßen Steuerungsvorrichtung, wobei die Brückenschaltung an einem Elektromotor angeschlossen ist,
- Fig. 2: eine Brückenschaltung ebenfalls 3-phasig mit einer Steuerungsvorrichtung gemäß einem zweiten bevorzugten Ausführungsbeispiel, wobei am Ausgang der Brückenschaltung ein Elektromotor mit drei Spulen angeschlossen ist,
- Fig. 3: ein Strom-Zeit-Diagramm im Falle eines Gleichspannungs-Kurzschlusses,
- Fig. 4: ein Strom-Zeit-Diagramm im Falle eines High-Side FET-Kurzschlusses, und
- Fig. 5: ein Strom-Zeit-Diagramm im Falle eines Low-Side FET-Kurzschlusses.

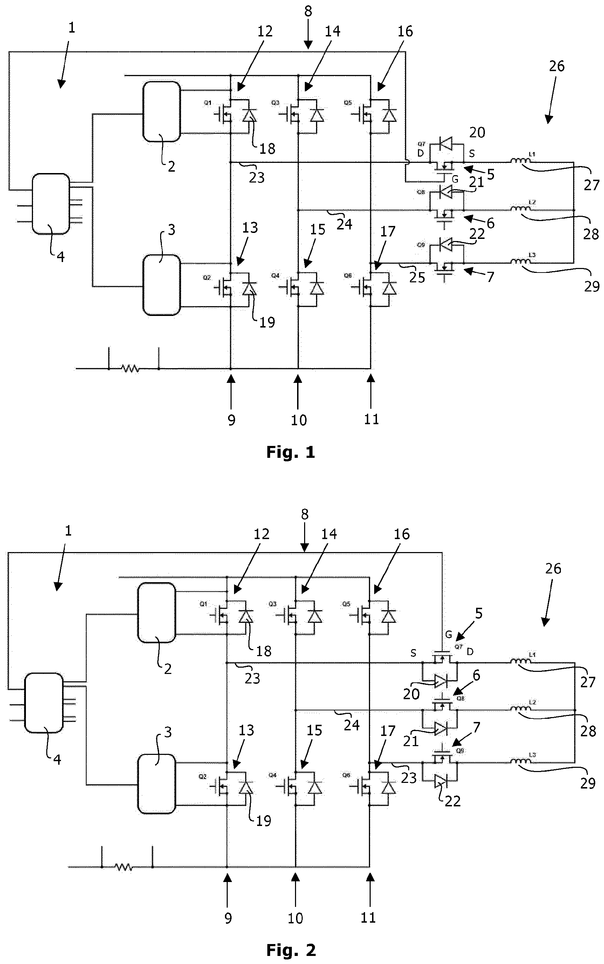

Fig. 1 zeigt eine 3-phasige Brückenschaltung 8 als Wechselrichter, die eine ersten, einen zweiten und einen dritten Brückenzweig 9, 10 und 11 aufweist. Diese Brückenzweige sind parallel zueinander angeordnet. Jeder Brückenzweig 9, 10 und 11 weist jeweils einen High-Side Feldeffekttransistor 12, 14, 16 und einen Low-Side Feldeffekttransistor 13, 15, 17 sowie einen Wechselstromausgang 23, 24, 25 zwischen den beiden FETs auf. Die HS-FET 12, 14 und 16 sind jeweils mit ihrem Drain-Anschluss an einem positiven Potenzial einer Gleichspannung angeschlossen, während die LS-FET 13, 15 und 17 mit ihrem Source-Anschluss an einem negativen Potenzial der Gleichspannung angeschlossen sind. Jeder FET wird mit seiner Bodydiode gezeigt, die parallel zwischen Drain- und Source-Anschluss ausgebildet ist. Bei der HS-FET 12 des ersten Brückenzweigs 9 handelt es sich um Bodydiode 18, und bei der LS-FET 13 des ersten Brückenzweigs 9 handelt es sich um Bodydiode 19. Bei den anderen beiden Brückenzweigen 10 und 11 sind die FETs identisch ausgebildet. Jeder FET ist mit einem Spannungsmesser verbunden, um insbesondere die Bodydiodenspannung zwischen Drain und Source zu messen. In Fig. 1 ist insbesondere der Spannungsmesser 2 des HS-FET 12 und ein zweiter Spannungsmesser 3 des LS-FET 13 dargestellt, die Teil der erfindungsgemäßen Steuerungsvorrichtung 1 sind. Die Steuerungsvorrichtung 1 weist die Spannungsmesser (nur 2, 3 sind dargestellt), die Logikschaltung 4 und die Phasenisolatoren 5, 6, 7 auf. Alle sechs Spannungsmesser sind mit einer Logikschaltung 4 verbunden, die abhängig von den Mess- und/oder Zustandswerten, die von den Spannungsmessern ausgegeben werden, ein Steuersignal an die entsprechenden Phasenisolatoren 5, 6, 7 ausgibt. Die Steuersignale werden an die entsprechenden Gate-Anschlüsse der Phasenisolatoren 5, 6 und 7 geschickt, um einen Stromfluss durch diese abzustellen. Der Source-Anschluss der entsprechenden Phasenisolatoren 5, 6, 7 ist mit den Spulen 27, 28, 29 des Elektromotors 26 verbunden. Da die Bodydioden der Phasenisolatoren 5, 6, 7 die gleiche Durchgangsrichtung wie die Feldeffekttransistoren 12, 14 und 16 haben, werden die entsprechenden Phasenisolatoren dann abgeschaltet, wenn der Strom von der Spule 27, 28, 29 durch den Phasenisolator 5, 6, 7 zum entsprechenden High-Side Feldeffekttransistor verläuft. Sobald der entsprechende Phasenisolator gesperrt wird, kann der Strom über die entsprechende Bodydiode ausweichen, wodurch ein schlagartiger Stromabbruch unterbunden und der Phasenisolator vor einer Hochspannungsspitze geschützt werden kann.

Fig. 2 zeigt die gleiche 3-phasige Brückenschaltung 8 mit einem Elektromotor 26 und dessen Spulen 27, 28, 29. Die Steuerungsschaltung 1 unterscheidet sich von der aus Fig. 1 darin, dass die Phasenisolatoren 5, 6, 7 in umgekehrter Form, d. h. mit ihrem Drain-Anschluss an der Spule und ihrem Source-Anschluss an dem Wechselstromausgang 23, 24, 25, verbunden sind. Sobald also ein Strom durch die Bodydiode der Low-Side Feldeffekttransistoren und durch die Phasenisolatoren verläuft, kann der entsprechende Phasenisolator ausgeschalten werden, um den Strom zu sperren. Der Strom kann dabei durch die Bodydiode des Phasenisolators ausweichen.

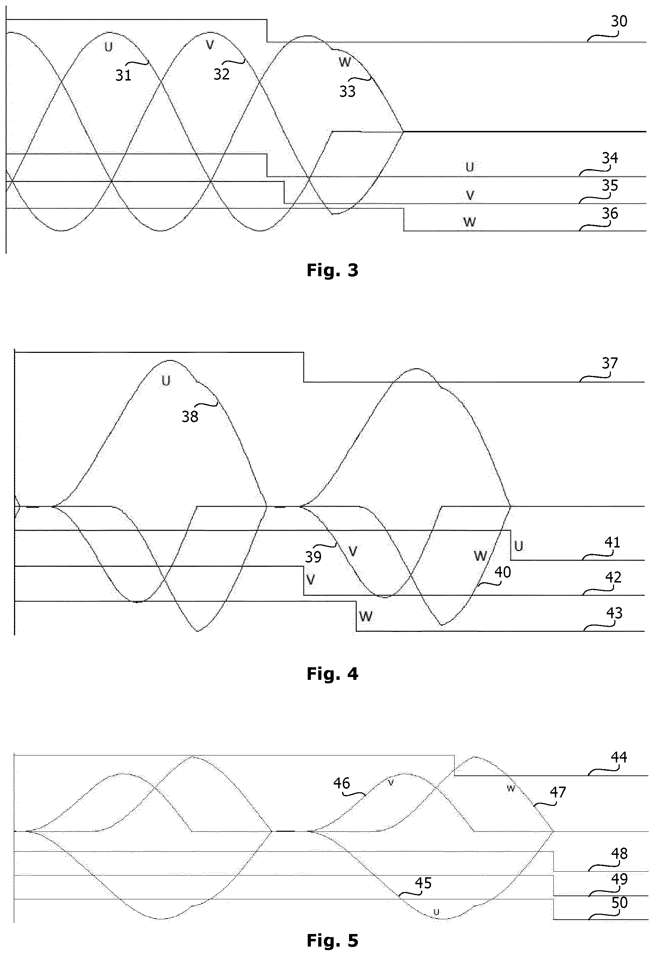

Die Figuren 3 bis 5 zeigen Strom-Zeit-Diagramme, wobei die Signalstärke verschiedener Ströme qualitativ dargestellt werden. Hierbei werden die Phasenströme U, V, W, ein Sperrsignal (oberstes Signal im Diagramm) und drei Steuersignale (drei unterste Signale im Diagramm) gezeigt. Die nachfolgend gezeigten Sperrsignale und Steuersignale weisen jeweils eine Stufe auf, die einem Ein- und Ausschaltsignal gleichkommt.

Fig. 3 zeigt ein Strom-Zeit-Diagramm mit den drei Phasen U, V, W bzw. Phase 31, 32, 33, die um 120° zueinander verschoben sind. Der Sperrbefehl A 30, der in der Logikschaltung der erfindungsgemäßen Steuerungsvorrichtung erzeugt oder empfangen wird, veranlasst die Steuerungsvorrichtung, die Phasenisolatoren zu sperren. Hierzu wird zuerst ein Steuersignal 34 für die Phase U, dann ein Steuersignal 35 für die Phase V und zum Schluss ein Steuersignal 36 für die Phase W ausgegeben, um jeweils die entsprechenden Phasenisolatoren zu sperren. Bei der Ausgabe der Steuersignale wird darauf geachtet, dass bestimmte Bedingungen erfüllt sind - der Strom der Phase muss negativ oder null sein. Wie man erkennt, ist nach dem Steuersignal 36 der komplette Phasenstrom auf null.

Fig. 4 zeigt ein Strom-Zeit-Diagramm, wobei in diesem Fall ein High-Side Feldeffekttransistor-Kurzschluss vorliegt. Dies zeichnet sich dadurch aus, dass die Phasen U, V und W bzw. Phase 38, 39, 40 nicht korrekt als Drehstrom erzeugt werden. Sobald der Sperrbefehl B 37 in der Logikschaltung erzeugt oder empfangen wurde, wird der Phasenisolator gesperrt, in dem der Strom durch die Bodydioden des Phasenisolators und des Low-Side Feldeffekttransistors durchgehen können. Dies ist in diesem Falle die Phasen V. Danach wird die Phase W und somit deren Phasenisolator gesperrt, und zum Schluss die Phase U für den letzten Phasenisolator. Schlussendlich ist der Phasenstrom komplett auf null und der Elektromotor vor etwaigen Beschädigungen durch Stromspitzen geschützt.

Fig. 5 zeigt ein Strom-Zeit-Diagramm, z.B. im Falle eines Low-Side FET-Kurzschlusses. Ähnlich wie in Fig. 4 sind die Phasen U, V, W bzw. Phasen 45, 46, 47 nicht als korrekter Drehstrom ausgebildet. Sobald der Sperrbefehl C 44 in der Logikschaltung erzeugt oder empfangen wurde, und keines der Spannungsmesser eine Stromführung der Bodydioden, insbesondere für einen bestimmten Zeitraum, detektiert, können alle Phasenisolatoren gleichzeitig abgeschaltet werden.

### Bezugszeichenliste

- 1: Steuerungsvorrichtung
- 2: Spannungsmesser des HS-FET des ersten Brückenzweigs
- 3: Spannungsmesser des LS-FET des ersten Brückenzweigs
- 4: Logikschaltung
- 5: FET der Phase U als erster Phasenisolator (Q7)
- 6: FET der Phase V als zweiter Phasenisolator (Q8)
- 7: FET der Phase W als dritter Phasenisolator (Q9)
- 8: 3-phasige Brückenschaltung als Wechselrichter
- 9: Erster Brückenzweig
- 10: Zweiter Brückenzweig
- 11: Dritter Brückenzweig
- 12: High-Side Feldeffekttransistor, HS-FET, des ersten Brückenzweigs (Q1)
- 13: Low-Side Feldeffekttransistor, LS-FET, des ersten Brückenzweigs (Q2)
- 14: High-Side Feldeffekttransistor des zweiten Brückenzweigs (Q3)
- 15: Low-Side Feldeffekttransistor des zweiten Brückenzweigs (Q4)
- 16: High-Side Feldeffekttransistor des dritten Brückenzweigs (Q5)
- 17: Low-Side Feldeffekttransistor des dritten Brückenzweigs (Q6)
- 18: Bodydiode von Q1
- 19: Bodydiode von Q2
- 20: Bodydiode von Q7
- 21: Bodydiode von Q8
- 22: Bodydiode von Q9
- 23: Wechselstromausgang des ersten Brückenzweigs - Phase U
- 24: Wechselstromausgang des zweiten Brückenzweigs - Phase V
- 25: Wechselstromausgang des dritten Brückenzweigs - Phase W
- 26: Elektromotor
- 27: Erste Spule des Elektromotors (L1)
- 28: Zweite Spule des Elektromotors (L2)
- 29: Dritte Spule des Elektromotors (L3)
- 30: Sperrsignal A
- 31: Wechselstrom - Phase U
- 32: Wechselstrom - Phase V
- 33: Wechselstrom - Phase W
- 34: Steuersignal für Q7 - Phase U
- 35: Steuersignal für Q8 - Phase V
- 36: Steuersignal für Q9 - Phase W
- 37: Sperrsignal B
- 38: Wechselstrom - Phase U
- 39: Wechselstrom - Phase V
- 40: Wechselstrom - Phase W
- 41: Steuersignal für Q7 - Phase U
- 42: Steuersignal für Q8 - Phase V
- 43: Steuersignal für Q9 - Phase W
- 44: Sperrsignal C
- 45: Wechselstrom - Phase U
- 46: Wechselstrom - Phase V
- 47: Wechselstrom - Phase W
- 48: Steuersignal für Q7 - Phase U
- 49: Steuersignal für Q8 - Phase V
- 50: Steuersignal für Q9 - Phase W

## Patentansprüche

1. Steuerungsvorrichtung (1) für eine Brückenschaltung (8) zur gesteuerten Wechselstromerzeugung, die Brückenschaltung aufweisend mindestens einen Brückenzweig (9,10,11), der mindestens einen High-Side Feldeffekttransistor, FET (12,14,16), mindestens einen Low-Side FET (13,15,17) und einen dazwischenliegenden Wechselstromausgang (23,24,25) aufweist, wobei die Steuerungsvorrichtung
- einen Spannungsmesser (2,3) für jeden FET eines Brückenzweigs, wobei jeder Spannungsmesser zur Drain-Source-Spannungsmessung mit den jeweiligen FET verbindbar ist und Mess- und/oder Zustandswerte ausgibt;
- einen Feldeffekttransistor als Phasenisolator (5,6,7) für jeder Wechselstromausgang, wobei der/die Phasenisolator/en mit jeweils einem Wechselstromausgang verbindbar und durch jeweils ein Steuersignal schaltbar ist/sind; und
- eine Logikschaltung (4) zur Erfassung der Werte der Spannungsmesser und zur Ausgabe von Steuersignalen an jeweils einen Phasenisolator aufweist,
wobei die Logikschaltung anhand der erfassten Werte die Steuersignale zum Sperren des/der entsprechenden Phasenisolators/en ausgibt,
**dadurch gekennzeichnet, dass**
die Spannungsmesser ausgelegt sind, einen ersten und einen zweiten Zustand zu bestimmen und auszugeben:
- der erste Zustand liegt vor, wenn die gemessene Spannung unterhalb eines vorbestimmten Werts, insbesondere unterhalb von -0,5 Volt, liegt, und dient zum Bestimmen der Stromrichtung; und
- der zweite Zustand liegt vor, wenn die gemessene Spannung oberhalb des vorbestimmten Werts, insbesondere oberhalb von -0,5 Volt, liegt, und dient zum Bestimmen, dass entweder kein Strom durch die Bodydiode des FET fließt oder der FET einen Drain-Source-Kurzschluss hat und beschädigt ist.

2. Steuerungsvorrichtung nach Anspruch 1,
**dadurch gekennzeichnet, dass**
die Steuerungsvorrichtung eine Hauptsteuerschaltung aufweist, die den vorbestimmten Wert zu jeder Zeit und während des Betriebs der Steuerungsvorrichtung und/oder der Brückenschaltung bestimmen kann.

3. Steuerungsvorrichtung nach einem der Ansprüche 1 bis 2,
**dadurch gekennzeichnet, dass**
der Source-Anschluss des/der Phasenisolator/en mit einer mit dem Wechselstrom zu versorgenden Last (26) verbindbar ist/sind.

4. Steuerungsvorrichtung nach Anspruch 3,
**dadurch gekennzeichnet, dass**
die Logikschaltung ausgelegt ist, beim Erfassen einer durch einen Spannungsmesser gemessenen Stromführung an einem High-Side FET ein Steuersignal zum Sperren des Phasenisolators des zugehörigen High-Side FET Wechselstromausgangs auszugeben.

5. Steuerungsvorrichtung nach Anspruch 4,
**dadurch gekennzeichnet, dass**
die Logikschaltung ausgelegt ist, anhand der erfassten Werte zu bestimmen, dass der High-Side FET keinen Kurzschluss aufweist und eine Stromführung in der Bodydiode des High-Side FET in die leitende Richtung der Bodydiode des entsprechenden Phasenisolators erfolgt, und somit das Steuersignal zum Sperren des Phasenisolators des zugehörigen High-Side FET Wechselstromausgangs auszugeben.

6. Steuerungsvorrichtung nach einem der Ansprüche 1 bis 2,
**dadurch gekennzeichnet, dass**
der Drain-Anschluss des/der Phasenisolator/en mit der mit dem Wechselstrom zu versorgenden Last verbindbar ist/sind.

7. Steuerungsvorrichtung nach Anspruch 6,
**dadurch gekennzeichnet, dass**
die Logikschaltung ausgelegt ist, beim Erfassen einer durch einen Spannungsmesser gemessenen Stromführung an einem Low-Side FET ein Steuersignal zum Sperren des Phasenisolators des zugehörigen Low-Side FET Wechselstromausgangs auszugeben.

8. Steuerungsvorrichtung nach Anspruch 7,
**dadurch gekennzeichnet, dass**
die Logikschaltung ausgelegt ist, anhand der erfassten Werte zu bestimmen, dass der Low-Side FET keinen Kurzschluss aufweist und eine Stromführung in der Bodydiode des Low-Side FET in die leitende Richtung der Bodydiode des entsprechenden Phasenisolators erfolgt, und somit das Steuersignal zum Sperren des Phasenisolators des zugehörigen Low-Side FET Wechselstromausgangs auszugeben.

9. Steuerungsvorrichtung nach Anspruch 7,
**dadurch gekennzeichnet, dass**
die Logikschaltung ausgelegt ist, anhand der erfassten Werte zu bestimmen, dass der Low-Side FET keinen Kurzschluss aufweist und eine Stromführung in der Bodydiode des Low-Side FET in die leitende Richtung der Bodydiode des entsprechenden Phasenisolators erfolgt, und die Werte keine Stromführung in der Bodydiode des High-Side FET auf derselben Phase signalisieren, und somit das Steuersignal zum Sperren des Phasenisolators des zugehörigen Low-Side FET Wechselstromausgangs auszugeben.

10. Steuerungsvorrichtung nach Anspruch 7,
**dadurch gekennzeichnet, dass**
die Logikschaltung ausgelegt ist, nachdem zwei beliebige Phasenisolatoren bereits deaktiviert sind, anhand der erfassten Werte zu bestimmen, dass keine Stromführung in den Bodydioden der entsprechenden Low-Side FETs in die leitende Richtung erfolgt und die Werte keine Stromführung in der Bodydiode des High-Side FET auf der letzte Phase signalisieren, und somit das Steuersignal zum Sperren des Phasenisolators des letzten Low-Side FET Wechselstromausgangs auszugeben.

11. Steuerungsvorrichtung nach nach Anspruch 7,
**dadurch gekennzeichnet, dass**
die Logikschaltung ausgelegt ist, Steuersignale zum Sperren eines Phasenisolators auszugeben, wenn ein Spannungsmesser für die High-Side FET gerade seinen Zustand von eine Stromführung in der Bodydiode auf keine Stromführung in der Bodydiode ändert und die Spannungsmesser für die Low-Side FETs keine Stromführung in der Bodydiode auf den beiden anderen Phasen zeigen.

12. Steuerungsvorrichtung nach einem der Ansprüche 1 bis 10,
**dadurch gekennzeichnet, dass**
die Logikschaltung ausgelegt ist, Steuersignale zum Sperren aller Phasenisolatoren auszugeben, wenn kein Spannungsmesser eine Stromführung misst.

13. Steuerungsvorrichtung nach einem der Ansprüche 1 bis 10,
**dadurch gekennzeichnet, dass**
die Logikschaltung ausgelegt ist, Steuersignale zum Sperren aller Phasenisolatoren auszugeben, wenn alle Spannungsmesser auf der High-Side mindestens einmal eine Stromführung in der Bodydiode des High-Side FET zeigten, ohne dass ein Spannungsmesser eine Stromführung in der Bodydiode des Low-Side FET zeigte.

14. 3-phasige Brückenschaltung mit einer Steuerungsvorrichtung nach einem der Ansprüche 1 bis 13, die Brückenschaltung mit drei Brückenzweigen, wobei jeder Brückenzweig einen High-Side Feldeffekttransistor, FET, einen Low-Side FET und einen dazwischenliegenden Wechselstromausgang aufweist.

## Claims

1. Control device (1) for a bridge circuit (8) for controlled AC current generation, the bridge circuit having at least one bridge branch (9, 10, 11) that has at least one high-side field-effect transistor, FET (12, 14, 16), at least one low-side FET (13, 15, 17), and an AC output (23, 24, 25) therebetween, wherein the control device has
- a voltmeter (2, 3) for each FET of a bridge branch, wherein each voltmeter, in order to measure the drain-source voltage, is able to be connected to the respective FET and outputs measured values and/or state values;
- a field-effect transistor in the form of a phase isolator (5, 6, 7) for each AC output, wherein the phase isolator/isolators is/are able to be connected to a respective AC output and is/are able to be switched by a respective control signal; and
- a logic circuit (4) for detecting the values of the voltmeters and for outputting control signals to a respective phase isolator,
wherein the logic circuit outputs the control signals for turning off the corresponding phase isolator/isolators on the basis of the detected values,
**characterized in that**
the voltmeters are designed to determine and to output a first and a second state:
- the first state is present if the measured voltage is below a predetermined value, in particular below -0.5 volts, and serves to determine the current direction; and
- the second state is present if the measured voltage is above the predetermined value, in particular above -0.5 volts, and serves to determine that either no current is flowing through the body diode of the FET, or the FET has a drain-source short circuit and is damaged.

2. Control device according to Claim 1,
**characterized in that**
the control device has a main control circuit that can determine the predetermined value at any time and during operation of the control device and/or the bridge circuit.

3. Control device according to either of Claims 1 and 2,
**characterized in that**
the source connection of the phase isolator/isolators is/are able to be connected to a load (26) that is to be supplied with the AC current.

4. Control device according to Claim 3,
**characterized in that**
the logic circuit is designed, if it is detected that a current, which is measured by a voltmeter, is being carried on a high-side FET, to output a control signal for turning off the phase isolator of the associated high-side FET AC output.

5. Control device according to Claim 4,
**characterized in that**
the logic circuit is designed to determine, on the basis of the detected values, that the high-side FET does not have a short circuit and current is being carried in the body diode of the high-side FET in the conducting direction of the body diode of the corresponding phase isolator, and therefore to output the control signal for turning off the phase isolator of the associated high-side FET AC output.

6. Control device according to either of Claims 1 and 2,
**characterized in that**
the drain connection of the phase isolator/isolators is/are able to be connected to the load that is to be supplied with the AC current.

7. Control device according to Claim 6,
**characterized in that**
the logic circuit is designed, if it is detected that a current, which is measured by a voltmeter, is being carried on a low-side FET, to output a control signal for turning off the phase isolator of the associated low-side FET AC output.

8. Control device according to Claim 7,
**characterized in that**
the logic circuit is designed to determine, on the basis of the detected values, that the low-side FET does not have a short circuit and current is being carried in the body diode of the low-side FET in the conducting direction of the body diode of the corresponding phase isolator, and therefore to output the control signal for turning off the phase isolator of the associated low-side FET AC output.

9. Control device according to Claim 7,
**characterized in that**
the logic circuit is designed to determine, on the basis of the detected values, that the low-side FET does not have a short circuit and current is being carried in the body diode of the low-side FET in the conducting direction of the body diode of the corresponding phase isolator, and the values do not signal current being carried in the body diode of the high-side FET on the same phase, and therefore to output the control signal for turning off the phase isolator of the associated low-side FET AC output.

10. Control device according to Claim 7,
**characterized in that**
the logic circuit is designed to determine, after two arbitrary phase isolators have already been deactivated, and on the basis of the detected values, that current is not being carried in the body diodes of the corresponding low-side FETs in the conducting direction, and the values do not signal current being carried in the body diode of the high-side FET on the last phase, and therefore to output the control signal for turning off the phase isolator of the last low-side FET AC output.

11. Control device according to Claim 7,
**characterized in that**
the logic circuit is designed to output control signals for turning off a phase isolator if a voltmeter for the high-side FET is changing its state from a current being carried in the body diode to no current being carried in the body diode, and the voltmeters for the low-side FETs do not show a current being carried in the body diode on the two other phases.

12. Control device according to one of Claims 1 to 10,
**characterized in that**
the logic circuit is designed to output control signals for turning off all the phase isolators if no voltmeter measures a current being carried.

13. Control device according to one of Claims 1 to 10,
**characterized in that**
the logic circuit is designed to output control signals for turning off all the phase isolators if all the voltmeters on the high side showed a current being carried in the body diode of the high-side FET at least once, without a voltmeter having showed a current being carried in the body diode of the low-side FET.

14. 3-phase bridge circuit comprising a control device according to one of Claims 1 to 13, the bridge circuit comprising three bridge branches, wherein each bridge branch has a high-side field-effect transistor, FET, a low-side FET, and an AC output therebetween.

## Revendications

1. Dispositif de commande (1) pour un circuit en pont (8) destiné à la production commandée de courant alternatif, le circuit en pont possédant au moins une branche de pont (9, 10, 11), laquelle possède au moins un transistor à effet de champ, FET, côté haut (12, 14, 16), au moins un FET côté bas (13, 15, 17) et une sortie de courant alternatif (23, 24, 25) se trouvant entre eux, le dispositif de commande possédant
- un mesureur de tension (2, 3) pour chaque FET d'une branche de pont, chaque mesureur de tension pouvant être relié au FET respectif en vue de mesurer la tension drain-source et délivrant en sortie des valeurs de mesure et/ou d'état ;
- un transistor à effet de champ faisant office d'isolateur de phase (5, 6, 7) pour chaque sortie de courant alternatif, le ou les isolateurs de phase pouvant être reliés respectivement à une sortie de courant alternatif et pouvant être commutés respectivement par un signal de commande ; et
- un circuit logique (4) destiné à acquérir les valeurs du mesureur de tension et à délivrer en sortie des signaux de commande respectivement à un isolateur de phase,
le circuit logique, à l'aide des valeurs acquises, délivrant en sortie les signaux de commande destinée à bloquer le ou les isolateurs de phase correspondants,
**caractérisé en ce que**
le mesureur de tension est conçu pour déterminer un premier et un deuxième état et délivrer en sortie :
- que le premier état est présent lorsque la tension mesurée est inférieure à une valeur prédéterminée, notamment inférieure à -0,5 volt, et sert à déterminer la direction du courant ; et
- que le deuxième état est présent lorsque la tension mesurée est supérieure à la valeur prédéterminée, notamment supérieure à -0,5 volt, et sert à déterminer soit qu'aucun courant ne circule à travers la diode intrinsèque du FET ou que le FET a un court-circuit entre le drain et la source et est endommagé.

2. Dispositif de commande selon la revendication 1, **caractérisé en ce que** le dispositif de commande possède un circuit de commande principal qui peut déterminer la valeur prédéterminée à tout moment pendant un fonctionnement du dispositif de commande et/ou du circuit en pont.

3. Dispositif de commande selon l'une des revendications 1 à 2, **caractérisé en ce que** la borne de source du ou des isolateurs de phase peut être reliée à une charge (26) à alimenter avec le courant alternatif.

4. Dispositif de commande selon la revendication 3, **caractérisé en ce que** le circuit logique est conçu pour, lors de la détection d'un passage de courant mesuré par un mesureur de tension au niveau d'un FET côté haut, délivrer en sortie un signal de commande destiné à bloquer l'isolateur de phase de la sortie de courant alternatif du FET côté haut associé.

5. Dispositif de commande selon la revendication 4, **caractérisé en ce que** le circuit logique est conçu pour, à l'aide des valeurs acquises, déterminer que le FET côté haut ne présente pas de court-circuit et qu'un passage du courant dans la diode intrinsèque du FET côté haut s'effectue dans le sens de la conduction de la diode intrinsèque de l'isolateur de phase correspondant, et ainsi délivrer en sortie le signal de commande destiné à bloquer l'isolateur de phase de la sortie de courant alternatif du FET côté haut associé.

6. Dispositif de commande selon l'une des revendications 1 à 2, **caractérisé en ce que** la borne de drain du ou des isolateurs de phase peut être reliée à la charge à alimenter avec le courant alternatif.

7. Dispositif de commande selon la revendication 6, **caractérisé en ce que** le circuit logique est conçu pour, lors de la détection d'un passage de courant mesuré par un mesureur de tension au niveau d'un FET côté bas, délivrer en sortie un signal de commande destiné à bloquer l'isolateur de phase de la sortie de courant alternatif du FET côté bas associé.

8. Dispositif de commande selon la revendication 7, **caractérisé en ce que** le circuit logique est conçu pour, à l'aide des valeurs acquises, déterminer que le FET côté bas ne présente pas de court-circuit et qu'un passage du courant dans la diode intrinsèque du FET côté bas s'effectue dans le sens de la conduction de la diode intrinsèque de l'isolateur de phase correspondant, et ainsi délivrer en sortie le signal de commande destiné à bloquer l'isolateur de phase de la sortie de courant alternatif du FET côté bas associé.

9. Dispositif de commande selon la revendication 7, **caractérisé en ce que** le circuit logique est conçu pour, à l'aide des valeurs acquises, déterminer que le FET côté bas ne présente pas de court-circuit et qu'un passage du courant dans la diode intrinsèque du FET côté bas s'effectue dans le sens de la conduction de la diode intrinsèque de l'isolateur de phase correspondant et que les valeurs ne signalent pas de passage du courant dans la diode intrinsèque du FET côté haut sur la même phase, et ainsi délivrer en sortie le signal de commande destiné à bloquer l'isolateur de phase de la sortie de courant alternatif du FET côté bas associé.

10. Dispositif de commande selon la revendication 7, **caractérisé en ce que** le circuit logique est conçu pour, après que deux isolateurs de phase quelconques sont déjà désactivés, à l'aide des valeurs acquises, déterminer qu'aucun passage du courant dans les diodes intrinsèques des FET côté bas correspondants n'a lieu et que les valeurs ne signalent pas de passage du courant dans la diode intrinsèque du FET côté haut sur la dernière phase, et ainsi délivrer en sortie le signal de commande destiné à bloquer l'isolateur de phase de la sortie de courant alternatif du FET côté bas associé.

11. Dispositif de commande selon la revendication 7, **caractérisé en ce que** le circuit logique est conçu pour délivrer en sortie des signaux de commande destinés à bloquer un isolateur de phase lorsqu'un mesureur de tension pour le FET côté haut modifie justement son état d'un passage du courant dans la diode intrinsèque à aucun passage du courant dans la diode intrinsèque et les mesureurs de tensions pour les FET côté bas d'indiquent aucun passage de courant dans la diode intrinsèque sur les deux autres phases.

12. Dispositif de commande selon l'une des revendications 1 à 10, **caractérisé en ce que** le circuit logique est conçu pour délivrer en sortie des signaux de commande destinés à bloquer tous les isolateurs de phase lorsqu'aucun mesureur de tension ne mesure un passage de courant.

13. Dispositif de commande selon l'une des revendications 1 à 10, **caractérisé en ce que** le circuit logique est conçu pour délivrer en sortie des signaux de commande destinés à bloquer tous les isolateurs de phase lorsque tous les mesureurs de tension sur le côté haut ont indiqué au moins une fois un passage de courant dans la diode intrinsèque du FET côté haut, sans qu'un mesureur de tension n'ait indiqué un passage de courant dans la diode intrinsèque du FET côté bas.

14. Circuit en pont triphasé comprenant un dispositif de commande selon l'une des revendications 1 à 13, le circuit en pont comprenant trois branches de pont, chaque branche de pont possédant un transistor à effet de champ, FET, côté haut, un FET coté bas et une sortie de courant alternatif se trouvant entre eux.
